# EUROPEAN PATENT APPLICATION

(11) **EP 4 684 896 A1**
(43) Date of publication of application: **28.01.2026**
(21) Application number: 24773933.7
(22) Date of filing: 08.03.2024
(51) Int. Cl.: B22F 3/093, B22F 9/04, B22F 1/17, C23C 14/24, C23C 14/16, B22F 3/10, B22F 3/14

(54) **GRADIENT STRUCTURE WEAR-RESISTANT COMPOSITE MATERIAL AND PREPARATION METHOD THEREOF**

(30) Priority: 23.03.2023 CN 202310292338
(71) Applicant: Hunan Hechang New Materials Co., Ltd, Changsha, Hunan 410604 (CN)
(72) Inventor: WANG, Xiaofeng, Changsha, Hunan 410083 (CN); ZHOU, Chaohui, Changsha, Hunan 410604 (CN)
(74) Representative: Franke, Dirk
(86) International application number: PCT/CN2024/080699
(87) International publication number: WO 2024/193366

(57) **Abstract**

The present invention relates to a gradient structure wear-resistant composite material and its preparation method, belonging to the field of powder metallurgy technology. The invention solves the technical problem of poor impact resistance of hard alloys and non-metallic materials in existing technology. The method includes: a fine-grained wear-resistant material powder is vacuum evaporated on the surface of coarse-grained wear-resistant material particles, and then the obtained surface modified coarse-grained wear-resistant material particles and fine-grained wear-resistant material powder are uniformly mixed with a solvent containing a dispersant to obtain a composite slurry. Then pour the composite slurry into a mold, vibrating, heating, and finally sintering. In this material, coarse-grained wear-resistant materials exhibit a gradient distribution in fine-grained wear-resistant materials, and can demonstrate good strength, toughness, and wear resistance under high-speed impact and long-term wear conditions.

## Description

### Related application

This application claims priority of Chinese invention application 202310292338.8, titled "A Gradient Structure Wear resistant Composite Material and Its Preparing Method," filed on March 23, 2023.

### TECHNICAL FIELD

The present invention belongs to the field of powder metallurgy technology, and specifically relates to a gradient structure wear-resistant composite material and its preparation method.

### Background

Hard alloy is a composite material made by powder metallurgy method, which uses hard compounds of refractory metal (such as WC or TiC) as the hard phase and transition group metals (such as Fe, Co, Ni and their alloys or high entropy alloys) as the bonding phase. Hard alloys have high hardness, strength, wear resistance, and corrosion resistance, and are widely used in military, aerospace, mechanical processing, metallurgy, petroleum drilling, mining tools, electronic communication, construction, and other fields.

However, hard alloys are expensive and have poor impact resistance. In order to further expand the application fields of hard alloys, it is necessary to improve the impact resistance of hard alloys.

Introducing gradient structure is a way of modifying hard alloys. A gradient structured high cobalt YG hard alloy for forming molds and its preparation method have been disclosed in a Chinese patent (Publication No. 115725884A). This method adds proper amount of TiN powder to the raw materials Co powder, W powder, and WC powder for preparing high cobalt YG hard alloy. The hardness and plastic deformation resistance of the high cobalt YG hard alloy are improved by the second hard phase TiN. At the same time, a strong thermodynamic coupling effect between Ti and N is used to obtain a hard alloy with a composition gradient structure, so that the surface of the hard alloy still maintains the WC-Co two-phase structure and high toughness. In addition, the sintered gradient hard alloy is subjected to cryogenic treatment to compensate for the decrease in transverse fracture strength of YG hard alloy caused by the introduction of TiN, thereby preparing a high hardness YG hard alloy. Gradient structured high cobalt YG hard alloy with strong resistance to plastic deformation and high strength. However, in the existing technology, gradient modification of hard alloys is mainly focused on the crystal structure, and no modification has been performed on the impact resistance of hard alloys.

In addition, non-metallic wear-resistant materials such as alumina, silicon nitride, silicon carbide, boron carbide, and boron nitride have high strength, high hardness, high temperature resistance, and good wear resistance. These non-metallic wear-resistant materials face similar problems during industrial applications as hard alloy materials. If non-metallic wear-resistant materials are used in large pieces or as a whole, their brittleness will be too high, and their impact resistance will be weak and fragile. If non-metallic materials can be combined with metallic materials to make the composite material have both the impact resistance of metallic materials and the high strength, high temperature resistance, and wear resistance of non-metallic materials, the performance of the material can be greatly improved. The composite of non-metallic materials and metallic materials has always been a difficult problem in the field of materials, especially the rare reports on the composite of wear-resistant non-metallic materials and wear-resistant metallic materials.

### Summary of the Invention

In view of this, the present invention provides a gradient structure wear-resistant composite material and its preparing method to solve the technical problems of expensive and poor impact resistance of hard alloys in the prior art. The inventor of this application has noticed during the research process that such composite method of the present invention also has certain applicability to non-metallic wear-resistant materials such as alumina, silicon nitride, silicon carbide, boron carbide, and boron nitride.

The technical solution adopted by the present invention to solve the above technical problems is as follows:

The present invention provides a method for preparing gradient structured wear-resistant composite materials, comprising the following steps:
Step S1: Mix coarse-grained wear-resistant material particles (with a bigger size) and fine-grained wear-resistant material powder (with a smaller size) uniformly in a volume ratio of 1:100~10:1, vacuum evaporating (put coarse-grained wear-resistant material particles and fine-grained wear-resistant material powder in an evaporating equipment, evaporating a layer of fine-grained wear-resistant material powder on the surface of coarse-grained wear-resistant material particles), and obtain surface modified coarse-grained wear-resistant material particles;
   the coarse-grained wear-resistant material particles are a mixture of one or more hard alloy particles, or a mixture of one or more non-metallic wear-resistant materials, or a mixture of one or more of the above-mentioned hard alloy particles and one or more non-metallic wear-resistant materials. The particle size range D₅₀ of the coarse-grained wear-resistant material particles is 1-200mm;
   the fine-grained wear-resistant material powder is an iron alloy powder, and the particle size range D₅₀ of the fine-grained wear-resistant material powder is 0.1-200 µ m;
Step S2: Mix the surface modified coarse-grained wear-resistant material particles, the remaining fine-grained wear-resistant material powder left from vacuum evaporating process of step S1, and a solvent containing a dispersant evenly to obtain a composite slurry;
Step S3: Pour the composite slurry into a mold, vibrate the mold, and after the vibration is completed, heat to remove the solvent in the composite slurry;
   the conditions for the vibration are: vibration frequency of 10 Hz~5000Hz, acceleration of 1 m/s2~1000m/s2, duration of 0.001h~10h;
Step S4: perform pressing treatment on the mold and sinter the material therein to obtain gradient structured wear-resistant composite materials.

Preferably, in step S1, the coarse-grained wear-resistant material particles are a mixture of one or more of WC based hard alloy particles, TiC-based hard alloy particles, TiCN-based hard alloy particles, and TiN-based hard alloy particles; Or the coarse-grained wear-resistant material particles are a mixture of one or more of aluminum oxide, zirconium oxide, silicon carbide, silicon nitride, boron carbide, and boron nitride, or the coarse-grained wear-resistant material particles are a mixture of one or more of the above-mentioned hard alloy particles and one or more non-metallic wear-resistant materials of aluminum oxide, zirconium oxide, silicon carbide, silicon nitride, boron carbide, and boron nitride.

Preferably, in step S1, the conditions for vacuum evaporation are: vacuum degree ≤ -0.1 MPa, evaporating temperature between 600~1200 °C, and lasting time between 0.1~200 h.

Preferably, in step S1, the iron alloy powder is a mixture of one or more of high chromium cast iron powder, manganese steel alloy powder, ductile iron powder, high manganese steel powder, and stainless steel.

Preferably, in step S2, the solvent is ethanol.

Preferably, in step S2, the dispersant is a mixture of one or more of polyvinyl alcohol, polyethylene glycol, polyvinyl butyraldehyde ester, and stearic acid.

Preferably, in step S2, the amount of dispersant used is 0.001 wt.% to 10 wt.% of the mass of the fine-grained wear-resistant material powder in step one. More preferred is 0.01wt% to 1wt%, and particularly preferred is 0.01wt% to 0.1wt%.

Preferably, in order to achieve uniform mixing in step S2, it adopts a method of wet grinding with a drum to mixing composite slurry. More preferably, grinding balls used for drum wet grinding are steel balls, hard alloy balls, or ceramic balls. More preferably, the conditions for drum wet grinding are: ball to material ratio of 0.1:10~10:0.1, ball milling time of 2h~48h, solid content of 10 vol.%~80 vol.%, and the rest as solvents.

Preferably, in step S3, the heating temperature is between 30 °C and 150 °C, and the heating time is between 0.1h and 10h.

Preferably, in step S4, the pressure range is 0.1 MPa~100 MPa, the heating rate is 0.01 °C/min~30 °C/min, the sintering temperature is 800 °C~1400 °C, and the sintering lasting time is 0.1 h~10 h.

The present invention also provides a gradient structure wear-resistant composite material prepared by above method.

### The principle of the present invention is:

The preparation method of the gradient structure wear-resistant composite material of the present invention involves evaporating a layer of fine-grained wear-resistant material powder on the surface of coarse-grained wear-resistant material particles. By such a manner, when the two kinds of materials are mixed, the potential difference between coarse-grained wear-resistant material particles and fine-grained wear-resistant material powder in the solvent can be reduced, thereby reducing the deposition difference between the two and making it difficult for fine-grained powder to settle to the bottom during subsequent vibration processes. The gradient structure can be controlled by utilizing the different behavior of coarse-grained wear-resistant material particles and fine-grained wear-resistant material powder modified on the surface of the mixed slurry under the same vibration conditions. Specifically, the greater the acceleration, the easier it is for the surface modified coarse-grained wear-resistant material particles to move downwards. The vibration frequency is suitable for controlling the particle gradient distribution of coarse-grained wear-resistant materials that can achieve better surface modification. If a layer of fine-grained wear-resistant material powder is not deposited on the surface of coarse-grained wear-resistant material particles, or the acceleration and vibration frequency are not controlled, the fine-grained wear-resistant material powder is prone to settle to the bottom, making it difficult for coarse-grained wear-resistant material particles to achieve gradient distribution. In addition, the deposition of a layer of fine-grained wear-resistant material powder on coarse-grained wear-resistant material particles is beneficial for sintering density in subsequent processes.

Compared with the prior arts, the beneficial effects of the present invention are as follows:
the preparation method of the gradient structure wear-resistant composite material of the present invention adopts a layer of fine-grained wear-resistant material powder deposited on the surface of coarse-grained wear-resistant material particles to reduce the settlement difference between the two kinds of particles, and then combined with vibration manner to form a gradient distribution of coarse-grained wear-resistant material, thereby preparing the gradient structure wear-resistant composite material. This method is simple to operate and suitable for large-scale production. And by adjusting the ratio of surface modified coarse-grained wear-resistant material particles to fine-grained wear-resistant material powders, as well as parameters such as vibration frequency and vibration duration, the gradient distribution can be controlled.

The gradient structure wear-resistant composite material prepared by the present invention is composed of coarse-grained wear-resistant material particles with excellent hardness and wear resistance, and fine-grained wear-resistant material powder with excellent impact toughness. The coarse-grained wear-resistant material particles are distributed in a gradient in the fine-grained wear-resistant material powder. In the composite material, the surface with more coarse-grained wear-resistant material particles exhibits good wear resistance, while the surface with more fine-grained wear-resistant material powder exhibits good impact resistance. The present invention realizes that wear-resistant composite materials can exhibit good strength, toughness, and wear resistance under high-speed impact and long-term wear conditions. Especially suitable for working conditions that require high wear resistance and impact toughness, such as the lining of ball mills, track pins of tracked vehicles, and bucket teeth of excavators.

### Brief Description of the Drawings

In order to describe the technical solution of the present invention more clearly, a brief introduction will be given to the drawings required for the embodiments. It is obvious that the drawings described below are only expressing some embodiments of the present invention. For those skilled in the art, other drawings can be adjusted based on these drawings without creative labor.
Figure 1 is a process flowchart of the preparation method of the gradient structure wear-resistant composite material of the present invention.
Figure 2 is a schematic diagram of the bottom cross-section of the gradient structure wear-resistant composite material of the present invention.
Figure 3 is a schematic diagram of the longitudinal section of the gradient structure wear-resistant composite material of the present invention.
Figure 4 is a figure of the bottom view of the gradient structure wear-resistant composite material obtained by Embodiment 1 of the present invention.
Figure 5 is a figure of the longitudinal view of the gradient structure wear-resistant composite material obtained by Embodiment 1 of the present invention.

### Examples

In order to further understand the present invention, the preferred Examples of the present invention are described below, but it should be understood that these descriptions are only for further illustration of the features and advantages of the present invention, and not for limitation of the claims of the present invention.

The preparation method of the gradient structure wear-resistant composite material of the present invention includes the following steps:
Step S1: Mix coarse-grained wear-resistant material particles and fine-grained wear-resistant material powder uniformly in a volume ratio of 1:100~10:1, perform a process of vacuum evaporation and form a layer of fine-grained wear-resistant material powder on the surface of coarse-grained wear-resistant material particles to obtain surface modified coarse-grained wear-resistant material particles;
Step S2: Mix the surface modified coarse-grained wear-resistant material particles with the remaining fine-grained wear-resistant material powder from step S1(i.e., after the process of vacuum evaporation of step S1, some of the fine-grained wear-resistant material powder would left, this step uses the left fine-grained wear-resistant material powder), and a solvent containing a dispersant evenly to obtain a composite slurry;
Step S3: Pour the composite slurry into a mold, vibrate the mold to form a gradient distribution of surface modified coarse-grained wear-resistant material particles, and at the same time, eliminate the air out of the composite slurry to fully fill the mold. Then, heat and remove the solvent;
Step S4: perform pressing treatment on the mold and sinter material therein to fully sinter the surface modified coarse-grained wear-resistant material particles and fine-grained wear-resistant material powder, densify them, form metallurgical bonding, and obtain gradient structured wear-resistant composite materials.

In step S1 of the above technical solution, the coarse-grained wear-resistant material particles are either one type of hard alloy particles or a mixture of multiple hard alloy particles. When it is a mixture of multiple hard alloy particles, there are no special restrictions on the mixing ratio of various kinds of hard alloy particles, which can be set according to the needs. Coarse grained wear-resistant material particles have good wear resistance, providing hardness and wear resistance for composite materials. The preferred coarse-grained wear-resistant material particles are a mixture of one or more of WC-based hard alloy particles, TiC-based hard alloy particles, TiCN-based hard alloy particles, and TiN-based hard alloy particles, which are mixed in any proportion, and more preferably are YG6 hard alloy particles, YG8 hard alloy particles, YT15 hard alloy particles, and YW1 hard alloy particles.

The coarse-grained wear-resistant material particles are a mixture of one or more of aluminum oxide, zirconium oxide, silicon carbide, silicon nitride, boron carbide, and boron nitride, or the coarse-grained wear-resistant material particles are a mixture of one or more of the above-mentioned hard alloy particles and one or more non-metallic wear-resistant materials of aluminum oxide, zirconium oxide, silicon carbide, silicon nitride, boron carbide, and boron nitride.

However, it should be noted that other hard alloy particles well-known to those skilled in the art are also applicable to the present invention. Any material with two or more properties of below can be used as coarse-grained wear-resistant material particles: high strength, high hardness, high temperature resistance, and good wear resistance. The coarse-grained wear-resistant material particles are millimeter sized particles, with a particle size range D₅₀ of 1-200mm, preferably 8-15mm, and more preferably 8-10mm.

In the above technical solution, in step S1, the fine-grained wear-resistant material powder is iron alloy powder or other alloy powder, preferably manganese steel alloy powder, such as manganese steel MN600, manganese steel MN400, 316L, QT900-2. Choose a fine-grained wear-resistant material that matches the material of its pre-bonded substrate. For Example, if the wear-resistant material of the present invention is pre-combined with high chromium cast iron or low carbon steel, the iron alloy powder is selected from high chromium cast iron powder or low carbon steel powder, or a material powder that is easy to combine with the substrate powder is selected.

Fine grained wear-resistant material powder has good impact resistance, providing impact toughness for composite materials. The fine-grained wear-resistant material powder is a micrometer sized powder with a particle size range D₅₀ of 0.1-200 µm, preferably 50-100 µm, and more preferably 50-80 µm.

In the above technical solution, in step S1, a layer of fine-grained wear-resistant material powder is evaporated on the surface of coarse-grained wear-resistant material particles, which can ensure that the potential of coarse-grained wear-resistant material particles and fine-grained wear-resistant material powder in the solvent is similar when they are mixed, thereby reducing the difference in sedimentation between the two kinds of materials. The volume ratio of coarse-grained wear-resistant material particles to fine-grained wear-resistant material powder is preferably 1:2~1:4, and more preferably 1:3.

In step S1 of the above technical solution, vacuum evaporation is usually carried out in a vacuum tank. The preferred conditions for vacuum evaporation are: vacuum degree ≤ -0.1MPa, temperature of 600-1200 °C, and time of 0.1-200h. It should be noted that as long as a layer of fine-grained wear-resistant material powder can be evaporated on the surface of coarse-grained wear-resistant material particles, other vacuum evaporation conditions that can achieve this effect can also be used by technical personnel in this field.

In step two of the above technical solution, the solvent is not particularly limited and which can act as a dispersing agent for surface modified coarse-grained wear-resistant material particles and fine-grained wear-resistant material powder can be selected. Ethanol is preferred. Those skilled in this field can also choose other solvents that can achieve the above effects according to their needs.

In step S2 of the above technical solution, the mixture is uniformly mixed by wet grinding with a drum. The preferred grinding balls for drum wet grinding are steel balls, hard alloy balls, or ceramic balls. The ratio of balls and materials is 0.1:10~10:0.1, preferably 1~2:1, and more preferably 1.5:1. The ball milling time is between 2 hours and 48 hours, with a preferred range of 1.5 hours to 6 hours and an even more preferred range of 3 hours to 4 hours; The solid content is 10 vol.% to 80 vol.%, preferably 20 vol.% to 30 vol.%, and more preferably 25 vol.%. It should be noted that other methods of uniform mixing that are well-known to those skilled in the art can also be used.

In step S2 of the above technical solution, the dispersant is a conventional additive in this field, which plays a role in promoting dispersion. The preferred dispersant in this Example is a mixture of one or more of polyvinyl alcohol, polyethylene glycol, polyvinyl butyraldehyde ester, and stearic acid. When it is a mixture of multiple dispersants, there are no special restrictions on the mixing ratio, which can be set according to the needs. The dosage of dispersant is 0.001 wt.% to 10 wt.% of the mass of fine-grained wear-resistant material powder in step S1, preferably 0.01wt%~1wt%, more preferably 0.01wt%~0.1wt%.

In step S3 of the above technical solution, it usually involves placing the mold on a vibration table to achieve vibration.

The vibration frequency ranges from 10 Hz to 5000 Hz, with a preferred range of 30 Hz to 200 Hz and an even more preferred range of 50 Hz to 100 Hz. The acceleration ranges from 1 m/s² to 1000 m/s², with a preferred range of 80 m/s² to 200 m/s² and an even more preferred range of 100 m/s² to 200 m/s². The duration is 0.001h~10h, preferably 0.01h~0.5h, and more preferably 0.1h~0.5h. Vibration is the core point of the present invention, which can achieve gradient distribution of surface modified hard alloy particles or non-metallic particles in fine-grained wear-resistant material powder through vibration (i.e., the distribution quantity of hard alloy particles or non-metallic particles forms a gradient, and the density increases from top to bottom), and the gradient distribution can be controlled by adjusting the ratio of surface modified coarse-grained wear-resistant material particles to fine-grained wear-resistant material powder, as well as parameters such as vibration frequency and vibration duration.

In step S3 of the above technical solution, the preferred heating temperature is 30 °C~150 °C, and more preferably 70 °C~80 °C. The preferred heating time is 0.1 h to 10 h, more preferably 1 h to 4 h, and particularly preferably 2 h to 3 h. Heating equipment is usually a blast drying oven. It should be noted that other heating devices of those skilled in the art are also applicable to the present invention.

In step S4 of the above technical solution, the preferred pressure range is 0.1 MPa to 100 MPa, more preferably 10 to 30 MPa, and particularly preferably 12 MPa. The preferred heating rate is 0.01 °C/min~30 °C/min, more preferably 5 °C/min~12 °C/min, and particularly preferably 8 °C/min~12 °C/min. The sintering temperature depends on the materials, and is preferably between 800 °C and 1400 °C. The sintering time is preferably between 0.1 h and 10 h, and more preferably between 1 h and 2 h. The equipment for mold pressure sintering usually uses a pressing machine. However, it should be noted that other pressing and sintering equipment of those skilled in the art are also applicable to the present invention.

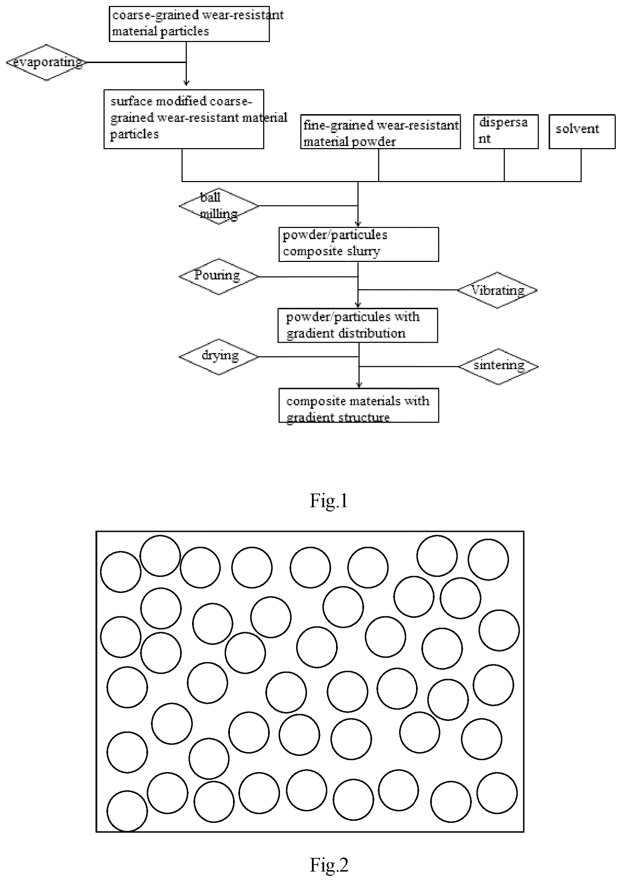

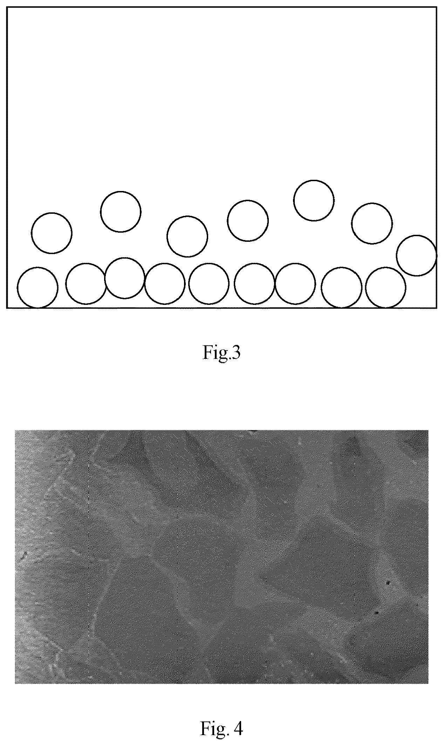

As shown in Figures 2 and 3, the gradient structure wear-resistant composite material prepared by the preparation method of the present invention is composed of coarse-grained wear-resistant material particles with excellent hardness and wear resistance, and fine-grained wear-resistant material powder with excellent impact toughness. The coarse-grained wear-resistant material particles are distributed in a gradient in the fine-grained wear-resistant material powder. In the composite material, the surface with more coarse-grained wear-resistant material particles exhibits good wear resistance, while the surface with more fine-grained wear-resistant material powder exhibits good impact resistance. This composite material is particularly suitable for working conditions that require high wear resistance and impact toughness, such as the lining of ball mills, track pins of tracked vehicles, and bucket teeth of excavators.

The terms used in the present invention generally have meanings that are commonly understood by those skilled in the art, unless otherwise specified. In order to enable those skilled in the field to better understand the technical solution of the present invention, the present invention will be further described in detail with reference to Examples.

The materials, reagents, devices, instruments, equipment, etc. used in the following Examples can be obtained from commercial sources unless otherwise specified.

The following Examples will further illustrate the present invention.

### Example 1

Take(weigh) 5kg of YG6 hard alloy particles (D₅₀ 15mm) and 10kg of manganese steel NM600 powder (D₅₀ 50 µm) and mix them together. Place them in a vacuum tank, vacuuming to -0.01MPa (not higher than -0.1MPa), and perform evaporating at 800 °C for 2 hours to evaporate a layer of manganese steel NM600 powder on the surface of YG6 hard alloy particles, obtaining surface modified YG6 hard alloy particles.

After cooling the obtained surface modified YG6 hard alloy particles to room temperature, the surface modified YG6 hard alloy particles and the remaining manganese steel NM600 powder from step one were added to an ethanol solution containing a dispersant (stearic acid, 0.01 wt.% weight of 10Kg manganese steel NM600 powder), and mixed them evenly by drum wet grinding. The mixture was ball milled for 3 hours to obtain a composite slurry, wherein the grinding ball used is YG6 hard alloy ball, with a ball to material ratio of 1:1. The solid content is 20 vol.%.

Pour the composite slurry into a mold placed on a vibration table, and fully fill the mold with the slurry through vibration. The surface modified YG6 hard alloy particles sink and form a gradient distribution. The parameters of the vibration table are set as follows: vibration frequency of 100HZ, acceleration of 100m/s², duration of 0.01h. Then, the mold is placed in an 80 °C blast drying oven and baked for 2 hours to remove the solvent.

Finally, place the mold on a hot press machine, apply pressure to 10MPa, and raise the temperature to 1100 °C at a rate of 5 °C/min for 2 hours to sinter and densify the surface modified YG6 hard alloy particles and manganese steel NM600 powder into a gradient structured powder/particle wear-resistant material.

The hardness, impact toughness, and wear resistance of the gradient structured powder/particle wear-resistant material prepared in this Example were tested. The hardness testing standard is GB/T 230.1-2018, the impact toughness testing standard is GB/T 229-2020, and the wear resistance testing standard is GB/T 34501-2017. After testing, the hardness of the wear-resistant material is 49.9 HRC, the impact toughness is 4.2 J/cm², and the abrasive wear is 1.1 g/10 min.

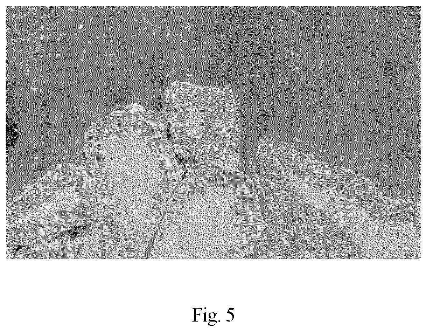

The gradient structured powder/particle wear-resistant material prepared in this Example was longitudinally and transversely cut at the bottom, as shown in Figures 5 and 4, respectively. From Figures 5 and 4, it can be seen that in the powder/particle wear-resistant material prepared in Example 1, the coarse-grained wear-resistant material particles are distributed in a gradient in the fine-grained wear-resistant material powder.

### Example 2

Take 5kg of YG8 hard alloy particles (D₅₀ 13mm) and 15kg of manganese steel NM400 powder (D₅₀ 80 µ m) and mix them together. Place them in a vacuum tank, vacuuming to -0.01MPa (not higher than -0.1MPa), and perform evaporating at 720 °C for 1.5 hours to obtain a layer of manganese steel NM400 powder on the surface of YG8 hard alloy particles, obtaining surface modified YG8 hard alloy particles.

After cooling to room temperature, the surface modified YG8 hard alloy particles and the remaining manganese steel NM400 powder from step S1 were added to an ethanol solution containing a dispersant (polyvinyl alcohol 0.05 wt.% of 15Kg manganese steel NM600 powder weight), and mixed them evenly by drum wet milling. The mixture was ball milled for 6 hours to obtain a composite slurry, wherein the grinding ball used is a steel ball with a ball to material ratio of 1.5:1. The solid content is 20 vol.%.

Pour the composite slurry into a mold placed on a vibration table, and fully fill the mold with the slurry through vibration. The surface modified YG8 hard alloy particles sink and form a gradient distribution. The parameters of the vibration table are set as follows: vibration frequency of 200HZ, acceleration of 200m/s², duration of 0.01h. Then, the mold is placed in an 80 °C blast drying oven and baked for 3 hours to remove the solvent.

Finally, place the mold on a hot press machine, apply pressure to 30MPa, and raise the temperature to 1100 °C at a rate of 12 °C/min for 2 hours to sinter and densify the surface modified YG8 hard alloy particles and manganese steel NM400 powder into a gradient structured powder/particle wear-resistant material. After testing, the hardness of the wear-resistant material is 57.4HRC, the impact toughness is 5.1 J/cm2, the abrasive wear is 1.1 g/10 min, and the coarse-grained wear-resistant material particles are distributed in a gradient in the fine-grained wear-resistant material powder. The testing standards are the same as in Example 1.

### Example 3

Take 4Kg of YT15 hard alloy particles (D₅₀ 10mm) and 16Kg of 316L powder (D₅₀ 50 µ m) and mix them together. Place them in a vacuum can and vacuuming to -0.01MPa (not higher than -0.1MPa). Evaporating the YT15 hard alloy particles at 850 °C for 1.5 hours to obtain a layer of 316L powder on the surface of the YT15 hard alloy particles, resulting in surface modified YT15 hard alloy particles.

After cooling to room temperature, the surface modified YT15 hard alloy particles and the remaining 316L powder from step S1 were added to an ethanol solution containing a dispersant (polyethylene glycol, 0.06 wt.% weight of 16Kg manganese steel NM600 powder), and mixed them evenly by wet rolling. The mixture was ball milled for 4 hours to obtain a composite slurry, wherein the grinding ball used is YT15 hard alloy ball, with a ball to material ratio of 1:1. The solid content is 30 vol.%.

Pour the composite slurry into a mold placed on the vibration table, and fully fill the mold with the slurry through vibration. The surface modified YT15 hard alloy particles sink and form a gradient distribution. The parameters of the vibration table are set as follows: vibration frequency of 50Hz, acceleration of 80m/s², duration of 0.5h. Then, the mold is placed in a 70 °C blast drying oven and baked for 1 hour to remove the solvent.

Finally, place the mold on a hot press machine, apply pressure to 12MPa, and raise the temperature to 1350 °C at a rate of 10 °C/min for 1 hour to sinter and densify the surface modified YT15 hard alloy particles and 316L powder into gradient structured powder/particle wear-resistant materials. After testing, the hardness of the wear-resistant material obtained in this Example is 53.2 HRC, the impact toughness is 4.2 J/cm2, the abrasive wear is 1.4 g/10 min, and the coarse-grained wear-resistant material particles are distributed in a gradient in the fine-grained wear-resistant material powder. The testing standards are the same as in Example 1.

### Example 4

Take 10kg of YW1 hard alloy particles (D₅₀ 8mm) and 20kg of QT900-2 powder (D₅₀ 100 µ m) and mix them. Place them in a vacuum can, vacuum to -0.01MPa (not higher than -0.1MPa), and evaporate them at 650 °C for 4 hours to obtain a surface modified YW1 hard alloy particle with a layer of QT900-2.

After cooling to room temperature, the surface modified YW1 hard alloy particles and the remaining QT900-2 powder from step S1 were added to an ethanol solution containing a dispersant (polyvinyl butyraldehyde ester, 0.05 wt.% weight of 20Kg manganese steel NM600 powder), and mixed them evenly by drum wet grinding. The mixture was ball milled for 1.5 hours to obtain a composite slurry, wherein the grinding balls used are hard alloy balls with a ball to material ratio of 2:1,and the solid content therein is 25 vol.%.

Pour the composite slurry into the mold placed on the vibration table, and fully fill the mold with the slurry through vibration. The surface modified YW1 hard alloy particles sink and form a gradient distribution. The parameters of the vibration table are set as follows: vibration frequency is 30HZ, acceleration is 80m/s², duration is 0.1h. Then, the mold is placed in a 70 °C blast drying oven and baked for 4 hours to remove the solvent.

Finally, place the mold on a hot press machine, apply pressure to 12MPa, and raise the temperature to 1000 °C at a rate of 8 °C/min for 1 hour to sinter and densify the surface modified YW1 hard alloy particles and QT900-2 powder into gradient structured powder/particle wear-resistant materials. After testing, the hardness of the wear-resistant material is 58.3 HRC, the impact toughness is 5.1 J/cm², the abrasive wear is 1.3 g/10 min, and the coarse-grained wear-resistant material particles are distributed in a gradient in the fine-grained wear-resistant material powder. The testing standards are the same as in Example 1.

### Example 5

Take 5kg of silicon carbide particles (D₅₀ 10mm) and 15kg of high chromium cast iron Cr15Mo3 powder (D₅₀ 50 µm) and mix them together. Place them in a vacuum tank, vacuum to -0.01MPa (not higher than -0.1MPa), and evaporate at 500 °C for 6 hours to obtain surface modified silicon carbide particles by depositing a layer of high chromium cast iron Cr15Mo3 on the surface of the silicon carbide particles.

After cooling to room temperature, the surface modified silicon carbide particles and the remaining Cr15Mo3 powder from step S1 were added to an ethanol solution containing a dispersant (polyvinyl butyraldehyde ester,which has a weight of 0.1 wt.% weight of 15Kg high chromium cast iron Cr15Mo3 powder), and mixed them evenly by wet grinding with a drum. The mixture was ball milled for 4 hours to obtain a composite slurry, wherein the grinding balls used are hard alloy balls with a ball to material ratio of 1:1 and the solid content is 20 vol.%.

Pour the composite slurry into a mold placed on the vibration table, and fully fill the mold with the slurry through vibration. The surface modified silicon carbide particles sink and form a gradient distribution. The parameters of the vibration table are set as follows: vibration frequency of 30HZ, acceleration of 150m/s², duration of 0.05h. Then, the mold is placed in an 80 °C blast drying oven and baked for 3 hours to remove the solvent.

Finally, place the mold on a hot press machine, apply pressure to 20MPa, and raise the temperature to 1200 °C at a rate of 10 °C/min for 0.5 hours to sinter and densify the surface modified silicon carbide particles and Cr15Mo3 powder into a gradient structured powder/particle wear-resistant material. After testing, the hardness of the wear-resistant material obtained by this Example is 70.1 HRC, the impact toughness is 4.8 J/cm2, the abrasive wear is 1 g/10 min, and the coarse-grained wear-resistant material particles are distributed in a gradient in the fine-grained wear-resistant material powder. The testing standards are the same as in Example 1.

### Example 6

Take 3kg of zirconia particles (D₅₀ 10mm) and 20kg of high chromium cast iron Cr29 powder (D₅₀ 30 µm) and mix them together. Place them in a vacuum can and vaccum to a pressure of -0.01MPa (not higher than -0.1MPa). Evaporate the zirconia particles at 800 °C for 1 hour to obtain surface modified zirconia particles by depositing a layer of high chromium cast iron Cr29 on the surface of the zirconia particles.

After cooling to room temperature, the surface modified zirconia particles and the remaining Cr29 powder from step S1 were added to an ethanol solution containing a dispersant (polyvinyl butyraldehyde ester, the amount of which is 0.08 wt.% by weight of 20Kg high chromium cast iron Cr29 powder), and mixed them evenly by wet rolling. The mixture was ball milled for 4 hours to obtain a composite slurry. Among them, the grinding ball used is zirconia ball, with a ball to material ratio of 3:1; The solid content is 22 vol.%.

Pour the composite slurry into a mold placed on the vibration table, and fully fill the mold with the slurry through vibration. The surface modified zirconia particles sink and form a gradient distribution. The parameters of the vibration table are set as follows: the vibration frequency is 40HZ, the acceleration is 160m/s², and the duration is 0.1h. Then, the mold is placed in a 75 °C blast drying oven and baked for 4 hours to remove the solvent.

Finally, place the mold on a hot press machine, apply pressure to 26MPa, and raise the temperature to 1200 °C at a rate of 5 °C/min for 2 hours to sinter and densify the surface modified zirconia particles and Cr29 powder into gradient structured powder/particle wear-resistant materials. After testing, the hardness of the wear-resistant material obtained in this Example is 78.2HRC, the impact toughness is 5.9 J/cm², the abrasive wear is 1.4 g/10 min, and the coarse-grained wear-resistant material particles are distributed in a gradient in the fine-grained wear-resistant material powder. The testing standards are the same as in Example 1.

Obviously, the above embodiments are only examples provided for clear explanation, and not limitations on the embodiments. For ordinary skilled in the relevant field, other forms of changes or modifications can be made based on the above explanation. It is not necessary and impossible to exhaustively list all embodiments here. The obvious changes or variations derived from this are still within the scope of protection of the present invention.

## Claims

1. A preparation method of gradient structure wear-resistant composite material, which includes the following steps:
Step S1: Mix coarse-grained wear-resistant material particles and fine-grained wear-resistant material powder uniformly in a volume ratio of 1:100~10:1, perform vacuum evaporate on the mixture, and obtain surface modified coarse-grained wear-resistant material particles;
the coarse-grained wear-resistant material particles are one type of hard alloy particles or a mixture of multiple kinds of hard alloy particles, and the particle size range D₅₀ of the coarse-grained wear-resistant material particles is 1-200mm;
the fine-grained wear-resistant material powder is iron alloy powder or manganese steel alloy powder, and the particle size range D₅₀ of the fine-grained wear-resistant material powder is 0.1-200 µ m;
Step S2: Mix the surface modified coarse-grained wear-resistant material particles, the remaining fine-grained wear-resistant material powder left after Step S1, and a solvent containing a dispersant evenly to obtain a composite slurry;
Step S3: Pour the composite slurry into a mold, vibrate the mold, and after the vibration is completed, heat it to remove the solvent in the composite slurry, wherein the conditions for the vibration are: vibration frequency: 10 Hz~5000Hz, acceleration: 1 m/s²~1000m/s², duration: 0.001h~10h;
Step S4: apply pressure on the mold and sinter the mold to obtain gradient structured wear-resistant composite materials.

2. The preparation method of gradient structure wear-resistant composite material according to claim 1, wherein in Step S1, the coarse-grained wear-resistant material particles are a mixture of one or more of below hard alloy particles: WC-based hard alloy particles, TiC-based hard alloy particles, TiCN-based hard alloy particles, and TiN-based hard alloy particles.

3. The preparation method of gradient structure wear-resistant composite material according to claim 2, wherein the coarse-grained wear-resistant material particles are a mixture of one or more of below particles: alumina particles, zirconia particles, silicon carbide particles, and silicon nitride particles, or the coarse-grained wear-resistant material particles are a mixture of one or more of hard alloy particles and one or more of below non-metallic wear-resistant materials particles: alumina particles, zirconia particles, silicon carbide particles, silicon nitride particles, boron carbide particles, and boron nitride particles.

4. The preparation method of gradient structure wear-resistant composite material according to claim 1, wherein in step S1, the conditions for vacuum evaporation are: vacuum degree ≤ -0.1MPa, temperature of 600-1200 °C, and time of 0.1-200h.

5. The preparation method of gradient structure wear-resistant composite material according to claim 1, wherein the iron alloy powder is high chromium cast iron powder, manganese steel alloy powder, ductile iron powder, high manganese steel powder, stainless steel powder, or a mixture of one or more of the above powders.

6. The preparation method of gradient structure wear-resistant composite material according to claim 1, wherein in step S2, the solvent is ethanol; the dispersant is a mixture of one or more of polyvinyl alcohol, polyethylene glycol, polyvinyl butyraldehyde ester, and stearic acid; and the dosage of the dispersant is 0.001 wt.% to 10 wt.% of the mass of the fine-grained wear-resistant material powder in step S1.

7. The preparation method of gradient structure wear-resistant composite material according to claim 1, wherein in step S2, uniform mixing is achieved through a manner of drum wet grinding, and the grinding balls used for drum wet grinding are steel balls, hard alloy balls or ceramic balls, wherein the conditions for drum wet grinding are: ball to material ratio of 0.1:10~10:0.1, ball milling time of 2h~48h, and solid content of 10 vol.%~80 vol.%.

8. The preparation method of gradient structure wear-resistant composite material according to claim 1, wherein in step S3, the heating temperature is 30 °C~150 °C and the heating time is 0.1h~10h.

9. The preparation method of gradient structure wear-resistant composite material according to claim 1, wherein in step S4, the pressure range during the process of applying pressure is 0.1 MPa~100 MPa, during sinter the heating rate is 0.01 °C/min~30 °C/min, the sintering temperature is 800 °C~1400 °C, and the sintering time is 0.1 h~10 h.

10. A gradient structure wear-resistant composite material prepared by the preparation method of any of claims 1-9.
